# EUROPEAN PATENT SPECIFICATION

(11) **EP 1 559 139 B1**
(45) Date of publication and mention of the grant of the patent: **29.05.2013**
(21) Application number: 03795839.4
(22) Date of filing: 30.10.2003
(51) Int. Cl.: H01L 21/762

(54) **METHOD OF DETACHING A THIN FILM AT MODERATE TEMPERATURE AFTER CO-IMPLANTATION**
VERFAHREN ZUM ABLÖSEN EINES DÜNNEN FILMS BEI MODERATER TEMPERATUR NACH KOIMPLANTATION
PROCEDE DE SEPARATION D'UNE COUCHE MINCE A UNE TEMPERATURE MOYENNE APRES IMPLANTATION CONJOINTE

(30) Priority: 07.11.2002 FR 0213935
(43) Date of publication of application: 03.08.2005
(73) Proprietor: Soitec, 38190 Bernin (FR); Commissariat à l'Énergie Atomique et aux Énergies Alternatives, 75015 Paris (FR)
(72) Inventor: CAYREFOURCQ, Ian, F-38330 Saint Nazaire Les Eymes (FR); BEN MOHAMED, Nadia, F-38140 Renage (FR); LAGAHE-BLANCHARD, Christelle, F-38134 Saint Joseph De Riviere (FR); NGUYEN, Nguyet-Phuong, F-38100 Grenoble (FR)
(74) Representative: Regimbeau
(86) International application number: PCT/EP2003/013148
(87) International publication number: WO 2004/042779

(56) References cited:
- US-A1- 2002 025 604
- US-A1- 2002 153 563
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 March 1998 (1998-03-02), pages 1086-1088, XP000742819 ISSN: 0003-6951 cited in the application

## Description

### Technical field

The present invention relates to a method of detaching a thin film from a substrate.

It relates advantageously to the case of a transfer of that thin film from the substrate, referred to as source substrate, to a support referred to as target substrate, applicable in particular in the case where the target substrate is made from a different material to that of the source substrate (the term heterostructure is then used). This target substrate can just be an intermediate support from which the thin film will later be detached.

Conventionally, the source substrate is fixed, for example, by molecular bonding, by one of its surfaces to the target substrate, then a thin film of the source substrate which extends along the target substrate is detached from the remainder of the source substrate, on which the procedure may then be iterated.

The invention has applications in particular in the fields of microelectronics, micro-mechanics, integrated optics and integrated electronics.

It makes it possible, for example, to produce assemblies referred to as structures in which the thin film, which is of a material selected for its physical properties, is transferred to a support in order to form a stack of several layers (two or more). Thus, the advantages of the materials of the thin film and of the support may be combined. The transfer of a thin film may in particular make it possible to associate in a single structure parts which prima facie have incompatibilities such as a large difference in thermal expansion coefficients (for example: silicon on fused silica SOQ, SiC on silicon, etc.)

The target substrate is not necessarily a bulk support. Thus the invention also relates to the case in which a single thick layer is deposited on the implanted face (or on the face to be implanted); after detachment, a "self-supporting" thin film is obtained which may then, if useful, be fixed to a bulk target substrate.

Thin film is conventionally understood to mean a layer of which the thickness is of the order of a few tens of angströms to several micrometers. A thick layer is thus a layer having a thickness typically of at least several micrometers, or even several tens of micrometers.

### Context of the problem and prior art

The detachment of the thin film from the remainder of the source substrate is based on the observation that an implantation of chemical species in the source substrate may induce the formation of a zone of defects at a given depth. These defects may be micro-bubbles and/or platelets and/or micro-cavities and/or dislocation loops and/or other crystalline defects, disrupting the crystalline quality of the material, of which the nature, the density and the size are strongly dependent on the species implanted as well as on the nature of the source substrate. A heat-treatment may then be applied to enable the development of specific defects present in the weakened zone, which will enable the detachment of the thin film from the source substrate to be obtained later. This has in particular been described in the document US-5 374 564 and developments thereof, such as the document US-6 020 252.

The implantation step has been the subject of numerous research projects and studies in the specific field of SOI. In that context the problem to resolve is generally to reduce the implantation doses in order, on the one hand, to reduce the costs of manufacture by reducing the time of use of the machine, and, on the other hand, from a technological point of view, to reduce the zone damaged by the implantation.

Thus, for example, Agarwal et al (1997) gave an account, in "Efficient production of silicon-on-insulator films by co-implantation of He+ with H+", Applied Physics Letters, Volume 72, Number 9, 2 March 1998, of trials carried out by applying ions of two types, that is to say a co-implantation of the two species hydrogen and helium, in a silicon substrate. The authors specify that the implantation profiles of the two implanted species must be localized at the same depth, around which the concentration in implanted species is maximum and it is at that location that propagation of the splitting will be induced. The authors teach that the order of implantation of the two implanted species is important: hydrogen must be implanted first, helium second. They comment that it is thus possible to reduce the total implanted dose by a factor of the order of three in relation to the use of each species alone.

More particularly, this document discloses trials with low doses (7.5 x 10¹⁵/cm² H⁺ and 1 x 10¹⁶/cm² He ; or 1 x 10¹⁶/cm² H⁺ and 1 x 10¹⁶/cm² He) on the SOI. The detachment is then obtained at a usual temperature (500°C) with a low total implanted dose.

It may be noted that this document describes an experimental approach and gives little importance to the target substrate.

Similar teachings may be found in US-2002/0025604 which concerns a low-temperature semiconductor layering and three-dimensional electronic circuits using the layering. Such layering method includes several steps. First hydrogen and then helium are implanted at doses between 1.10¹⁶cm⁻² and 4.10¹⁶cm⁻² with a range that is close to each other. Implanted wafer is then bonded to another wafer. The bonded wafers are then annealed at low temperature between 200-250° for 1 to 48 hours and annealed at 400-600°C for 1 to 10 minutes so that a portion of the wafer is detached. This document concerns layering silicon on a silicon substrate.

The problem is posed in a very different manner in the case of heterostructures, that is to say in the case in which the materials of the source and target substrates are different. In this case, one of the major technological problems encountered is the presence of a field of very high stress in the various layers in contact, during the heat-treatment such as that during which the detachment of the thin film from the remainder of the source substrate occurs: this stress field is due to the difference in coefficients of thermal expansion between the various materials brought into contact.

Thus, in the case of substrates with different thermal expansion coefficients (heterostructure), it is important to manage to achieve the detachment at a lower temperature than the critical temperature at which the heterostructure will be degraded on account of the aforementioned mechanical stresses. This degradation may typically result in the breakage of one or both substrates brought into contact and/or in the substrates becoming unbonded at the bonding interface. For example, in a heterostructure comprising a implanted substrate of Si bonded to a fused silica substrate, the detachment of the Si layer on the fused silica substrate is accompanied by the breakage of the substrates if the heterostructure is subjected to a heat-treatment at 500°C. It is thus desirable to reduce the heat-treatment temperature to avoid the breakage or any damage of the heterostructure (and/or of the two substrates obtained after detachment) and to maintain a good quality for the transferred layer.

The same need to be able to use a relatively low detachment temperature is met when compounds are formed in one of the substrates (for example in the future thin film) and are liable to be degraded during a heat-treatment which is too aggressive.

One way to reduce the temperature of obtainment of the detachment is to "play" with the implantation conditions. For example, an excess dose of the implanted species makes it possible to reduce the thermal budget for detachment, thermal budget being understood to mean the pair Length of heat-treatment/Temperature of heat-treatment.

Bruel et al. (ECS Spring Meeting 1999) have thus shown that if the source substrate is a wafer of silicon, a dose of hydrogen ions implanted at 1 x 10¹⁷/cm², instead of at 5.5 x 10¹⁶/cm², makes it possible, for a limited duration of heat-treatment of a few hours, to reduce the detachment temperature from 425°C to 280°C.

This approach, although reducing the thermal budget for detachment, uses an implantation at high dose which may represent a significant drawback from an industrial point of view (high cost). Furthermore, it is of note that, due to the high implanted dose, the disrupted zone (comprising defects related to the implantation) at the surface of the transferred layer is thicker and the later processing operations necessary to eliminate that disrupted superficial zone may be more restrictive (greater removal of material, corresponding to more costly processing and potentially increasing the nsks of lack of homogeneity of the thickness of the transferred layer).

Another idea to reduce the temperature of detachment is described in the document US-A-5 877 070 (Gosele et al). It consists in implanting firstly an element involving the formation of hydrogen traps (in particular boron, carbon, phosphorus, nitrogen, arsenic or fluorine, that is to say elements of considerable size) then implanting the hydrogen in the source substrate, and in carrying out an operation of prior annealing before bonding of the source and target substrates According to the inventors this enables the detachment temperature to be reduced by 50% in comparison with the case of implantation of H⁺ alone. The invention relies on two steps: co-implantation (in which the hydrogen is introduced secondly) and a pre-annealing of the source substrate.

The invention relates to a method of detaching a thin film from a source substrate (for example fixed beforehand onto a target substrate, advantageously of a different material to that of the source substrate), which does not require implantation doses that are too high nor the annealing of the source substrate after implantation (and, where the case anses, before its bonding onto the target substrate), while permitting the detachment at a temperature sufficiently low not to induce, when the source substrate is fixed to a target substrate and when their coefficients of thermal expansion are different, prohibitive mechanical stresses on the heterostructure constituted by the two substrates, and/or not to nsk degrading components which may have been formed on one of the substrates before detachment.

### Presentation of the invention

To that end, the invention provides a method of detaching a thin film from a source substrate according to claim 1.

The invention is thus based on the implantation of two different species, characterized by different levels of efficacy to jointly form a weakened zone in the source substrate. One of the implanted species is chosen so as to localize the zone in which detachment will later occur by the formation of specific defects, the other is chosen to form a gas reservoir which will promote the extension of the specific defects designated previously, in particular by increasing their internal pressure.

The implantation of the first species, creating defects which promote detachment, is made firstly whereas the implantation of the other species, made so as to localize that second species in the zone of the defects created by the first species, is made secondly. This implantation order makes it possible to obtain a more favorable detachment dynamic.

In other words, implantation is carried out firstly of the first species, which has a high level of efficacy in creating a weakened layer (weakened is understood to mean the formation of specific defects of the micro-cavity and/or platelet etc. type), whereas, in this weakened layer, the second species, of lower efficacy in forming weakening defects, is implanted using a moderate dose. Being available in the weakened zone, the atoms of this second species will become trapped at or near the micro-cavities and/or platelets created at the time of the first implantation. At the time of the heat-treatment intended to induce detachment, the atoms of that second species will already be in place to participate in pressurizing the cavities present in the weakened layer and to enable their development; it follows from this that it is useful to choose as the second species a species having a high capacity to induce an effect of pressure in the cavities and/or micro-cracks located in the weakened layer. Nevertheless, it is possible to implant the second species first, which will later be available to progressively fill the defects which will be created by the implantation of the first species.

The first species is advantageously hydrogen (in one of its forms, for example in the form of H⁺ ions), the modes of implantation of which are well known, but it should be understood that other species may be used. Furthermore, the second species is advantageously helium which makes it possible to efficaciously generate a pressurizing effect.

A radical difference of this method, with respect to the experimental technique described in the work of Agarwal, is that the dose implanted of the first species is sufficient to form a weakened zone enabling detachment at a first temperature: the dose of this first species thus remains within conventional levels of the order of some 10¹⁶ atoms/cm² for hydrogen. The implanted dose of the second species is moderate such that all the atoms of the second species substantially find their place in the defects created by the first, and/or they create the least possible other defects liable to be unfavorable to the propagation of splitting; and the detachment is carried out at a second temperature which is less than the first temperature.

In comparison with the document US-5 877 070, in which the dose recommended for the species intended to generate defects (boron, for example) is much less than the dose of the hydrogen (typically between 0.1% and 1% of that dose) and in which intermediate annealing is imperative, the method of the invention teaches proportions that are the inverse and requires no intermediate heat-treatment (even if, of course, such an intermediate heat treatment remains possible provided that it is at a sufficiently low temperature not to commence detachment).

It may be rioted that this method differs from the teaching of above discussed US-2002/0025604 by the fact that the second species is implanted at a lower dose than the first one, and that the splitting is carried on at a temperature less than the one at which splitting would occur as a result of the first species only (about 500°C in practice).

Preferred provisions of the invention (already set out or not), possibly combined together are set out in the dependent claims.

### Description of the invention

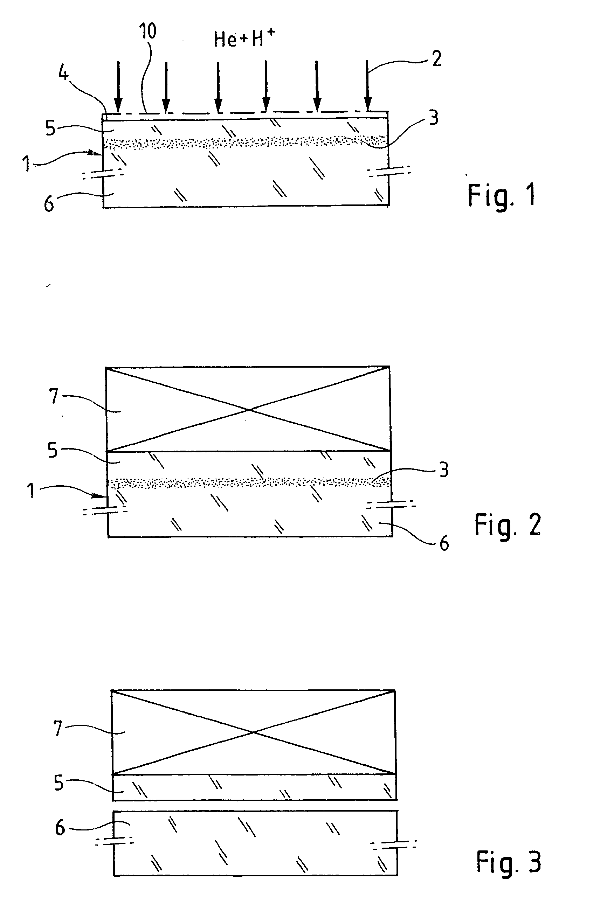

Aims, features and advantages of the invention will appear from the following description, given by way of illustrative non-limiting example, with reference to the accompanying drawings in which:
● Figure 1 is a diagram of a source substrate in course of implantation,
● Figure 2 is a later view of same after bonding to a target substrate; and
● Figure 3 is a view of same in course of detachment of a thin film deriving from the source substrate.

Figure 1 thus shows a substrate 1, for example of silicon advantageously oxidized on its surface 4, which may be covered by a protective layer 10, in the course of being subjected to an implantation treatment, symbolized by the arrows 2, for example by bombardment with ions or gaseous species.

This implantation involves, at the same given depth, two species, one of which is adapted to form defects, for example H⁺ hydrogen, and the other, for example helium, is adapted to occupy the defects formed previously or subsequently by that first species.

The implantation of the first species is carried out at a sufficient dose for it, by itself, to enable later detachment at a first temperature (see below), whereas the dose of the second species is lower than it.

Commencement is advantageously made by implanting the first species, hydrogen in the example considered (even if the second species may, as a variant, be implanted first). The second species is then implanted at a dose which advantageously just allows it to fill the defects generated by the first species and/or which creates the least possible other defects liable to be unfavorable for obtaining splitting later.

A buried zone 3 results from this, weakened by the presence of defects, principally generated by the first species, to the development of which the second species will contribute, in particular by its capability to pressurize those defects.

The weakened zone 3 delimits, within the source substrate, a future thin film 5 and a substrate remainder 6, that is to say that which remains of the source substrate after detachment of the thin film; this remainder will be able to serve as source substrate for an iteration of the procedure.

Figure 2 represents a step during the course of which the source substrate, containing the buried weakened zone, is joined by its face 4 with a target substrate 7, for example by direct molecular bonding.

In a later step, without any intermediate heat-treatment being necessary, detachment of the thin film from the remainder of the source substrate is carried out as represented in Figure 3, by splitting in the weakened zone. This splitting is carried out at a lower temperature than that for which splitting could have been obtained after implantation of solely the first species. This second temperature for the step of Figure 3 is lower by at least of the order of 200°C to that for which detachment could be obtained with the implanted dose of solely the first species; thus, if the first temperature is of the order of 500°C the actual splitting or detachment temperature is advantageously at most 300°C. Of course, these temperatures persist for reasonable periods of treatment, typically between a few tens of minutes and a few hours (for example up to 3 hours). In other words, the thermal budgets (temperature-duration pairs) are industrially realistic.

This detachment step may comprise, in addition to a thermal effect, the application of forces for example mechanical forces; in such case, what is stated in relation to the first and second temperatures also applies in the same way to the application of forces, that is to say that the first temperature would enable detachment after implantation of solely the first species on a given application of mechanical forces, but that detachment is obtained at the second temperature by the same application of mechanical forces.

This detachment or splitting step is advantageously followed by a step of thermal stabilization of the bonding between the target substrate 7 and the thin film. This step may include some time at a temperature above 1 000°C, preferably at about 1 100°C; this treatment may be conducted at a constant temperature, or at a varying temperature (for example oscillating between two values). It helps to prevent defects at the bonding interface or to prevent disbanding of the film layer from the target substrate.

The source substrate 1 may not only be of silicon but more generally of any appropriate known material (for example a III-V semiconductor), single crystal or polycrystalline or even amorphous. As for the target substrate 7, this may be of a wide variety of materials, to be chosen according to needs, single crystal, or polycrystalline (for example semiconductors) or even be amorphous (for example types of glass or polymers, etc.).

### Examples

According to a first embodiment of the invention, a substrate of Si (~700µm) comprising a layer of thermal SiO₂ on the surface (for example 200nm) may be implanted initially with hydrogen atoms under implantation conditions of 30keV - 4.5 x 10¹⁶ H/cm² and then be implanted with helium under the conditions of 45keV - 2 x 10¹⁶ He/cm². This source substrate may next be joined to a target substrate of fused silica (~1000µm) by direct bonding. The difference that exists between the coefficients of thermal expansion of these two materials (2.56 x10⁻⁶/°C for silicon and

0.5 x 10⁻⁶/°C for fused silica, at ambient temperature) makes it necessary to perform a heat-treatment for detachment at low temperature, typically being around 250-300°C. A heat-treatment around 275°C next induces the growth of the cavities localized at the peak hydrogen level, the helium atoms participating in the pressurization and in the development of those cavities. Final splitting at the level of the hydrogen profile leads to the transfer of the Si layer onto the substrate of fused silica, without breakage or degradation of either of the substrates derived from the heterostructure after splitting (the fused silica substrate having the thin film of Si on the one hand, and the initial Si substrate having had the superficial thin film peeled from it on the other hand).

According to another embodiment of the invention, a substrate of Si (~300µm) comprising a layer of thermal SiO₂ on the surface (for example 400nm) may be implanted initially with hydrogen atoms under implantation conditions of 95keV - 6 x 10¹⁶ H/cm² and then be implanted with helium under the conditions of 145keV - 2 x 10¹⁶ He/cm². This source substrate may next be joined to a target substrate of sapphire (~500µm) by direct bonding. A layer of oxide will optionally have been deposited on the surface of the sapphire substrate before bonding. The difference that exists between the coefficients of thermal expansion of these two materials (2.56 x10⁻⁶/°C for silicon and 5 x 10⁻⁶/°C for sapphire, at ambient temperature) makes it necessary, in the case of thick substrates, to perform a heat-treatment for detachment at low temperature, typically being less than 250°C. A heat-treatment around 200°C next induces the growth of the cavities localized at the peak hydrogen level, the helium atoms participating in the pressurization and in the development of those cavities. Final splitting at the hydrogen profile leads to the transfer of the Si layer on the sapphire substrate, without breakage or degradation of either of the substrates derived from the heterostructure after detachment (the sapphire substrate having the thin film of Si on the one hand, and the initial Si substrate having had the superficial thin film peeled from it on the other hand).

It may be noted that in the two aforementioned examples, the dose of the second species is at most equal to half of the dose of the first species.

According to a further embodiment a silicon substrate comprising a layer of thermal SiO₂ (of about 200nm) may be implanted first with helium atoms under implant conditions of 100keV at 1.10¹⁶ at/cm² and then implanted with hydrogen at 52 keV - 4.10¹⁶ atoms/cm². This source substrate is then joined to a handle silicon substrate. A heat treatment around 275°C for less than 15 hours in conducted to induce growth of cavities localized at the peak of hydrogen concentration level, the helium atoms participating in the pressurization of the cavities by their migration. Final splitting at the same low temperature is obtained and leads to the transfer of a silicon layer on the handle silicon substrate.

In variant forms which are not detailed:
- the source substrate is another semiconductor of Group IV, such as germanium,
- the source substrate is a semiconductor compound, for example of III-V type, for example AsGa or InP in particular.
- the source substrate is an insulator, for example of niobate or tantalite type, such as LiNbO₃ or LiTaO₃, in particular,
- the target substrate is made from a crystalline material other than sapphire,
- the target substrate is made from another amorphous material such as a glass other than fused silica or from a polymer,
- the target substrate is a simple stiffening layer, for example of oxide a few tens of nanometers thick, deposited by any appropriate technique of deposit; it no longer corresponds to a bulk target substrate as in the represented cases.
- the target substrate, when present, can just be an intermediate support.

## Claims

1. A method of detaching a thin film from a source substrate comprising the following steps:
• implanting ions or gaseous species in the source substrate so as to form therein a buried zone weakened by the presence of defects;
• splitting in the weakened zone leading to the detachment of the thin film from the source substrate
this method being **characterized in that**
- the implanting step comprises, on the one hand, a sub-step according to which a first species is implanted which is adapted to form defects in a zone in which detachment will later occur and, on the other hand, a sub-step according to which a second species, different from the first species, is implanted so as to localize the second species in the zone of the defects formed by implantation of the first species, the implantation of the first species being made at a sufficient dose to permit, alone, detachment of the thin film at a first temperature, and the implantation of the second species being made at a dose lower than the dose of the first species, and
- the splitting is carried out at a second temperature that is less than the first temperature by at least 200°C.

2. A method according to claim 1, **characterized in that** the second temperature is at most 300°C.

3. A method according to claim 1 or 2, **characterized in that** the second dose is less that the first dose by at least 10 %.

4. A method according to any one of claims 1 to 3, **characterized in that** implanting of the first species is carried out before that of the second species.

5. A method according to any one of claims 1 to 4, **characterized in that** the source substrate is made from a material chosen from the group consisting of semiconductors and insulators, single crystal, polycrystalline or amorphous.

6. A method according to claim 5, **characterized in that** the source substrate is made from a material chosen from the Group IV semiconductors.

7. A method according to claim 6 **characterized in that** the source substrate is made from silicon.

8. A method according to claim 5, **characterized in that** the source substrate is made from a semiconductor material of Group III-V or type,

9. A method according to claim 5, **characterized in that** the source substrate is made from an insulator chosen from the group consisting of LiNbO3 and LiTaO3.

10. A method according to any one of claims 1 to 5, **characterized in that** the first species is hydrogen.

11. A method according to claim 10, **characterized in that** the first species is hydrogen H⁺.

12. A method according to any one of claims 1 to 4 or 10 to 11, **characterized in that** the second species is helium.

13. A method according to claim 12, **characterized in that** the helium is implanted at a dose of 1 x10¹⁶ to 5 x 10¹⁶ atoms/cm².

14. A method according to any one of claims 1 to 5, **characterized in that**, before splitting in the weakened zone, the source substrate is bonded by its implanted face to a target substrate.

15. A method according to claim 14, **characterized in that** the target substrate is of an amorphous material.

16. A method according to claim 15, **characterized in that** the target substrate is of fused silica.

17. A method according to claim 14, **characterized in that** the target substrate is of a single crystal or polycrystalline material.

18. A method according to claim 17, **characterized in that** the target substrate is of sapphire.

19. A method according to any one of claims 14 to 18, **characterized in that** the source substrate and the target substrate are brought into intimate contact by direct bonding.

20. A method according to any one of claims 14 to 19, **characterized in that**, after splitting, a thermal stabilization step is applied to the bonding interface.

21. A method according to any one of claims 1 to 5, **characterized in that**, before splitting in the weakened zone, a stiffening layer is deposited on the implanted face of the source substrate.

## Patentansprüche

1. Verfahren zum Lösen einer dünnen Schicht von einem Quellsubstrat, das folgendes umfasst:
- Implantieren von Ionen oder Gasspezies in dem Quellsubstrat, sodass darin eine vergrabene Zone gebildet wird, die durch das Vorhandensein von Defekten geschwächt ist;
- Spalten in der geschwächten Zone, was zum Lösen der dünnen Schicht von dem Quellsubstrat führt,
wobei dieses Verfahren **dadurch gekennzeichnet ist, dass**
- das Implantieren einerseits einen Unterschritt umfasst, gemäß dem eine erste Spezies implantiert wird, die ausgestaltet ist, Defekte in einer Zone zu bilden, in der später Lösen stattfinden wird, und andererseits einen Unterschritt umfasst, gemäß dem eine zweite Spezies, die sich von der ersten Spezies unterscheidet, implantiert wird, sodass die zweite Spezies in der Zone der Defekte lokalisiert wird, die durch Implantieren der ersten Spezies gebildet wird, wobei das Implantieren der ersten Spezies ausreichend dosiert ist, um alleine Lösen der dünnen Schicht bei einer ersten Temperatur zu gestatten, und das Implantieren der zweiten Spezies niedriger dosiert ist als das der ersten Spezies dosiert ist, und
- das Spalten bei einer zweiten Temperatur durchgeführt wird, die um wenigstens 200°C niedriger ist als die erste Temperatur.

2. Verfahren nach Anspruch 1, **dadurch gekennzeichnet, dass** die zweite Temperatur höchstens 300°C beträgt.

3. Verfahren nach Anspruch 1 oder 2, **dadurch gekennzeichnet, dass** die zweite Dosis wenigstens 10% geringer als die erste Dosis ist.

4. Verfahren nach einem der Ansprüche 1 bis 3, **dadurch gekennzeichnet, dass** Implantieren der ersten Spezies vor dem der zweiten Spezies durchgeführt wird.

5. Verfahren nach einem der Ansprüche 1 bis 4, **dadurch gekennzeichnet, dass** das Quellsubstrat aus einem Material hergestellt ist, das aus der Gruppe gewählt ist, die aus Halbleitern und Isolatoren, einkristallinen, polykristallinen oder amorphen besteht.

6. Verfahren nach Anspruch 5, **dadurch gekennzeichnet, dass** das Quellsubstrat aus einem Material hergestellt ist, das aus Gruppe-IV-Halbleitern gewählt ist.

7. Verfahren nach Anspruch 6, **dadurch gekennzeichnet, dass** das Quellsubstrat aus Silizium hergestellt ist.

8. Verfahren nach Anspruch 5, **dadurch gekennzeichnet, dass** das Quellsubstrat aus einem Halbleitermaterial vom Typ der Gruppen III bis V hergestellt ist.

9. Verfahren nach Anspruch 5, **dadurch gekennzeichnet, dass** das Quellmaterial aus einem Isolator hergestellt ist, der aus der Gruppe gewählt ist, die aus LiNb03 und LiTaO3 besteht.

10. Verfahren nach einem der Ansprüche 1 bis 5, **dadurch gekennzeichnet, dass** die erste Spezies Wasserstoff ist.

11. Verfahren nach Anspruch 10, **dadurch gekennzeichnet, dass** die erste Spezies Wasserstoff H⁺ ist.

12. Verfahren nach einem der Ansprüche 1 bis 4 oder 10 bis 11, **dadurch gekennzeichnet, dass** die zweite Spezies Helium ist.

13. Verfahren nach Anspruch 12, **dadurch gekennzeichnet, dass** das Helium mit einer Dosis von 1 x 10¹⁶ bis 5 x 10¹⁶ Atomen/cm² implantiert ist.

14. Verfahren nach einem der Ansprüche 1 bis 5, **dadurch gekennzeichnet, dass** vor dem Spalten der geschwächten Zone das Quellsubstrat mit seiner implantierten Seite mit einem Zielsubstrat verbunden wird.

15. Verfahren nach Anspruch 14, **dadurch gekennzeichnet, dass** das Zielsubstrat ein amorphes Material ist.

16. Verfahren nach Anspruch 15, **dadurch gekennzeichnet, dass** das Zielsubstrat Quarzglas ist.

17. Verfahren nach Anspruch 14, **dadurch gekennzeichnet, dass** das Zielsubstrat ein einkristallines oder polykristallines Material ist.

18. Verfahren nach Anspruch 17, **dadurch gekennzeichnet, dass** das Zielsubstrat aus Saphir ist.

19. Verfahren nach einem der Ansprüche 14 bis 18, **dadurch gekennzeichnet, dass** das Quellsubstrat und das Zielsubstrat in innigem Kontakt durch direktes Bonden gebracht sind.

20. Verfahren nach einem der Ansprüche 14 bis 19, **dadurch gekennzeichnet, dass** nach dem Spalten thermisches Stabilisieren auf die Bondgrenzfläche angewendet wird.

21. Verfahren nach einem der Ansprüche 1 bis 5, **dadurch gekennzeichnet, dass** vor dem Spalten der geschwächten Zone eine Versteifungsschicht auf der implantierten Fläche des Quellsubstrats abgeschieden wird.

## Revendications

1. Procédé de détachement d'une couche mince d'un substrat source comprenant les étapes suivantes:
• implantation d'ions ou d'espèces gazeuses dans le substrat source de façon à y former une zone enterrée fragilisée par la présence de défauts;
• fracture dans la zone fragilisée menant au détachement de la couche mince d'avec le substrat source
ce procédé étant **caractérisé en ce que**
- l'étape d'implantation comporte, d'une part, une sous-étape selon laquelle on implante une première espèce apte à former des défauts dans une zone dans laquelle le détachement surviendra ultérieurement et, d'autre part, une sous-étape selon laquelle on implante une seconde espèce différente de la première, de façon à localiser la seconde espèce dans la zone des défauts formés par l'implantation de la première espèce, l'implantation de la première espèce étant faite à une dose suffisante pour permettre, à elle seule, un détachement de la couche mince à une première température, et l'implantation de la seconde espèce étant faite à une dose inférieure à la dose de la première espèce, et
- la fracture est effectuée à une seconde température inférieure à la première température d'au moins 200°C.

2. Procédé selon la revendication 1, **caractérisé en ce que** la seconde température est au plus de 300°C.

3. Procédé selon la revendication 1 ou 2, **caractérisé en ce que** la seconde dose est inférieure à la première dose d'au moins 10 %.

4. Procédé selon l'une des revendications 1 à 3, **caractérisé en ce qu'**on réalise l'implantation de la première espèce avant celle de la seconde espèce.

5. Procédé selon l'une quelconque des revendications 1 à 4, **caractérisé en ce que** le substrat source est fait d'un matériau choisi parmi le groupe constitué des semi-conducteurs et des isolants, monocristallins, polycristallins ou amorphes.

6. Procédé selon la revendication 5, **caractérisé en ce que** le substrat source en fait d'un matériau choisi parmi les semi-conducteurs du groupe IV.

7. Procédé selon la revendication 6, **caractérisé en ce que** le substrat source est en silicium.

8. Procédé selon la revendication 5, **caractérisé en ce que** le substrat source est un matériau semi-conducteur du type du groupe III-V.

9. Procédé selon la revendication 5, **caractérisé en ce que** le substrat source est un matériau isolant choisi dans le groupe constitué par LiNbO₃ et LiTaO₃.

10. Procédé selon l'une quelconque des revendications 1 à 5, **caractérisé en ce que** la première espèce est de l'hydrogène.

11. Procédé selon la revendication 10, **caractérisé en ce que** la première espèce est de l'hydrogène H⁺.

12. Procédé selon l'une quelconque des revendications 1 à 4 ou 10 ou 11, **caractérisé en ce que** la seconde espèce est l'hélium.

13. Procédé selon la revendication 12, **caractérisé en ce que** l'hélium est implanté à une dose de 1.10¹⁶ à 5.10¹⁶ atomes/cm².

14. Procédé selon l'une quelconque des revendications 1 à 5, **caractérisé en ce que**, avant la fracture dans la zone fragilisée, on fixe le substrat source par sa face implantée à un substrat cible.

15. Procédé selon la revendication 14, **caractérisé en ce que** le substrat cible est en un matériau amorphe.

16. Procédé selon la revendication 15, **caractérisé en ce que** le substrat cible est en silice fondue.

17. Procédé selon la revendication 14, **caractérisé en ce que** le substrat cible est un matériau monocristallin ou polycristallin.

18. Procédé selon la revendication 17, **caractérisé en ce que** le substrat cible est en saphir.

19. Procédé selon l'une quelconque des revendications 14 à 18, **caractérisé en ce que** le substrat source et le substrat cible sont mis en contact intime par collage direct.

20. Procédé selon l'une quelconque des revendications 14 à 19, **caractérisé en ce qu'**après la fracture, une étape de stabilisation thermique est appliquée à l'interface de collage.

21. Procédé selon l'une quelconque des revendications 1 à 5, **caractérisé en ce que**, avant la fracture dans la zone fragilisée, on dépose une couche de rigidification sur la face implantée du substrat source.
